# DEMANDE DE BREVET EUROPEEN

(11) **EP 4 296 112 A1**
(43) Date de publication de la demande: **27.12.2023**
(21) Numéro de dépôt: 23181244.7
(22) Date de dépôt: 23.06.2023
(51) Int. Cl.: B60L 53/16, H01R 12/58, H01R 13/66, H05K 1/18

(54) **DISPOSITIF DE CONNEXION RAPIDE POUR BORNE DE RECHARGE DE VEHICULES ELECTRIQUES ET BORNE DE RECHARGE DE VEHICULES ELECTRIQUES COMPRENANT AU MOINS UN TEL DISPOSITIF**

(30) Priorité: 24.06.2022 FR 2206329
(71) Demandeur: HAGER CONTROLS, 67700 Saverne (FR)
(72) Inventeur: MISSLER, Jean-Luc, 57720 OBERGAILBACH (FR); REINBOLD, Gregory, 67700 SAVERNE (FR); STURTZER, Eric, 67500 HAGUENAU (FR); WOHLFAHRT, Thomas, 67330 DOSSENHEIM-SUR-ZINSEL (FR)
(74) Mandataire: Cabinet Nuss

(57) **Abrégé**

La présente invention a pour objet un dispositif de connexion rapide pour borne de recharge de véhicules électriques, ladite borne de recharge comprenant un boîtier principal délimitant un espace interne, au moins une carte électronique (1) fixée dans l'espace interne, au moins une prise de recharge (2) fixée sur le boîtier principal ou connectée à l'extrémité d'un câble de recharge sortant du boîtier principal et se terminant par des points de raccordement, ladite prise de recharge comprenant des broches de sortie et des conducteurs reliés chacun à l'une de ces dernières.

Il se caractérise en ce qu'il comprend des interfaces de connexion (3, 4) comportant chacune un premier connecteur (3) apte et destiné à être connecté et assujetti à l'un des conducteurs ou points de raccordement du câble de recharge et un second connecteur (4) apte et destiné à être connecté et assujetti à la carte électronique (1), lesdits premiers et seconds connecteurs (3, 4) étant en outre apte et destinés à être assemblés l'un à l'autre par emboitement mâle/femelle mutuel de leurs embouts (3b, 4b) concernés respectifs. Elle a également pour objet une borne de recharge de véhicules électriques comprenant au moins un tel dispositif.

## Description

[La présente invention concerne le domaine des bornes de recharge des véhicules électriques et a pour objet un dispositif de connexion rapide pour borne de recharge de véhicules électriques. Elle a également pour objet une borne de recharge de véhicules électriques comprenant au moins un tel dispositif de connexion.

Pour recharger la batterie, également appelée accumulateur, d'un véhicule électrique, les particuliers et les professionnels utilisent de plus en plus des bornes de recharge fixées sur un support fixe tel qu'un mur par exemple. Elles permettent d'obtenir des temps de recharge plus courts (vitesses de recharges plus grandes) et des puissances de recharge plus élevées qu'avec les prises ordinaires, et sont plus sécurisées.

Une telle borne de recharge est alimentée en courant alternatif par un réseau de distribution électrique et comprend les circuits et prise(s) nécessaires pour fournir à la batterie à recharger un courant continu adapté aux caractéristiques de la batterie.

Plus particulièrement, la borne de recharge comprend un boîtier principal délimitant un espace interne, au moins une carte électronique (PCB) fixée dans l'espace interne, au moins une prise de recharge dédiée au chargement de la batterie de stockage d'un véhicule électrique et fixée et sur le boîtier principal ou connectée à l'extrémité d'un câble de recharge sortant du boîtier principal.

Par la suite, la ou chaque prise de recharge fixée sur le boîtier principal de la borne est appelée (ou définit) une prise de recharge fixe, également connue sous le nom de socle de prise de recharge ou de courant. La ou chaque prise de recharge connectée à l'extrémité du câble de recharge est appelée (ou définit) une prise de recharge mobile, également connue sous les noms de pistolet ou prise pistolet.

Une telle prise de recharge fixe ou mobile est une prise femelle permettant de connecter électriquement la borne de recharge à une prise de recharge mâle normalisée d'un véhicule électrique. Dans le cas d'une prise de recharge fixe, celle-ci est reliée, via un câble de recharge flexible mâle-femelle, à la prise du véhicule électrique. Le câble de recharge est muni à l'une de ses extrémités d'une prise mâle permettant d'assurer sa connexion à la ou l'une des prise(s) de recharge fixe(s) femelle(s) de la borne de recharge et à son autre extrémité d'une prise femelle permettant d'assurer sa connexion à la prise de recharge mâle normalisée du véhicule électrique à recharger. Dans le cas d'une prise de recharge mobile, celle-ci est connectée directement sur la prise de recharge mâle du véhicule électrique.

Ces prises de recharge fixes ou mobiles sont des pièces standards qui répondent aux normes ou règlementations dans ce domaine. Par exemple, la prise de recharge de type 2 est le standard européen imposée à l'ensemble des bornes de recharge et des véhicules électriques 100% électriques ou hybrides vendu(e)s dans l'union européenne. Elle comprend un boîtier (distinct du boîtier principal de la borne) et, sur un côté avant du boîtier, une pluralité de broches de sortie et, sur un côté arrière du boîtier, une pluralité de conducteurs rigides. Les conducteurs sont maintenus dans le boitier dans une position fixe les uns par rapport aux autres et sont reliés chacun à l'une des broches de sortie. Les conducteurs sont en outre reliés, par l'intermédiaires de câbles électriques flexibles, à la carte électronique de la borne principal de recharge pour connecter (électriquement) les broches de sortie à cette dernière.

Plus particulièrement, la prise de recharge comprend un ensemble de broches de sortie de contrôle, généralement deux broches de sortie de contrôle (« proximity pilot » (PP) et « Control Pilot » (CP)), pour la communication de la borne de recharge avec le véhicule électrique à recharger, notamment pour déterminer le niveau de courant maximum supportable par sa batterie et pour autoriser de façon intelligente la circulation du courant depuis la borne de recharge et un ensemble de broches de sortie d'alimentation, généralement cinq broches de sortie d'alimentation (une broche de terre, une broche de neutre et trois broches de phase) pour fournir l'alimentation en courant et la puissance à la batterie du véhicule électrique à recharger.

Toutefois, un problème rencontré avec ces bornes de recharge est la connexion des conducteurs de la prise de recharge à la carte électronique qui est réalisée par l'intermédiaire de câbles électriques flexibles. En effet, ces câbles électriques doivent être fixés aux conducteurs à l'aide de vis de serrage et à la carte électronique par l'intermédiaire d'un bornier lui-même fixé par brasage sur ladite carte, ce qui nécessite des temps de montage et de fixation élevés, ainsi que l'utilisation d'outils spécifiques, que ce soit pour le montage lors de la fabrication en usine ou sur le site du particulier ou du professionnel lors de l'installation, ou lors de la maintenance de la borne de recharge. D'autre part, le coût de matières premières, notamment du cuivre, dans les câbles électriques, entraîne des coûts de fabrication et des prix de revient élevés. En outre, pour un installateur privé ou professionnel, ces opérations sont contraignantes et peu aisées à réaliser et peuvent entraîner des risques d'échauffement, voire d'incendie, par exemple lorsque le couple de serrage des vis n'est pas correctement réalisé et/ou maitrisé par l'installateur. Enfin, la complexité de la fixation des câbles électriques limite la possibilité de réaliser en usine des grandes séries de bornes de recharge et dans des temps courts.

Le document WO 2020/167141 propose une solution visant à répondre à au moins une partie de ces problèmes créés par les prises de recharge actuelles d'où sortent les câbles pour la connexion des broches/conducteurs au « PCB » dans les bornes de recharges. Ce document concerne à cet effet un terminal de borne de recharge pour un chargeur de véhicule électrique, ledit terminal étant monté sur une carte électronique (carte de circuit imprimé (PCB)) pour former une seule pièce. Le terminal est conforme à une prise de recharge standard de type « 2 » et possède une pluralité de broches de sortie d'alimentation et de contrôle (portant des signaux de commande), une pluralité de conducteurs connectées chacun à l'une des broches de sortie et au PCB pour connecter les broches de sortie à ce dernier. Un support reçoit les conducteurs en les maintenant dans une position fixe les uns par rapport aux autres. Le terminal intègre également des fonctionnalités connues dans les prises de recharge actuelles tels que le moteur de verrouillage pour verrouiller le chargeur sur le câble de recharge du véhicule électrique lors de la charge.

Toutefois, si l'ensemble de terminal divulguée par le document WO 2020/167141 permet de supprimer la présence des câbles et le travail manuel de la connexion des câbles et d'éviter les opérations de vissages notamment, il n'offre pas une solution simple mais nécessite un ensemble de pièces complexe à réaliser et à assembler entre elles et sur le PCB pour reconstituer toutes les fonctionnalités d'une prise de recharge standard, notamment de type « 2 », c'est-à-dire y compris des fonctionnalités tels que le moteur de verrouillage de prise. En outre, les opérations de maintenance en cas de détérioration d'un élément, par exemple une broche, un conducteur ou le moteur de verrouillage, nécessitent de changer tout l'ensemble du terminal réalisé en une seule pièce/un seul bloc.

La présente invention a pour but de pallier ces inconvénients en proposant un dispositif de connexion rapide pour borne de recharge de véhicule électrique permettant d'obtenir des gains de temps de production, de réduire le coût de fabrication et de maintenance, de simplifier les opérations de montage en usine et sur site lors de l'installation ou de la maintenance de la borne de recharge, tout en réduisant les risques de mauvais câblage.

A cet effet, le dispositif de connexion rapide, selon la présente invention, pour borne de recharge de véhicules électriques, ladite borne de recharge comprenant un boîtier principal délimitant un espace interne, au moins une carte électronique fixée dans l'espace interne, au moins une prise de recharge dédiée au chargement de la batterie de stockage d'un véhicule électrique, la ou chaque prise de recharge étant soit fixe en étant fixée sur le boîtier principal, soit mobile en étant connectée à l'extrémité d'un câble de recharge sortant du boîtier principal, ladite prise de recharge fixe ou mobile comprenant des broches de sortie d'alimentation et/ou de communication et des conducteurs reliés chacun à l'une de ces dernières, l'autre extrémité du câble de recharge se terminant par des points de raccordement reliés chacun à l'un des conducteurs de la prise de recharge mobile, se caractérise essentiellement en ce qu'il comprend des interfaces de connexion aptes et destinées chacune à relier fonctionnellement la carte électronique à l'un desdits conducteurs ou points de raccordement, une telle liaison fonctionnelle réalisée par ledit dispositif de connexion rapide entre les conducteurs de la prise de recharge fixe et la carte électronique, ou entre les points de raccordement et la carte électronique, permettant de relier électriquement les broches de sortie de la prise de recharge fixe ou mobile à ladite carte électronique, chaque interface de connexion comportant un premier connecteur muni d'un embout de fixation et de connexion apte et destiné à être connecté et assujetti au conducteur ou point de raccordement concerné et d'un embout de connexion mâle ou femelle et un second connecteur muni d'un embout de fixation et de connexion apte et destiné à être connecté et assujetti à la carte électronique et d'un embout de connexion mâle ou femelle apte et destiné à être connecté à l'embout de connexion du premier connecteur par emboitement mutuel desdits embout de connexion, les premiers et seconds connecteurs présentant une forme globalement cylindrique et en ce que l'embout de connexion mâle des premiers ou seconds connecteurs comprend un corps allongé et rigide et une enveloppe métallique élastique externe entourant ledit corps de sorte à pouvoir assurer une connexion électrique et un ajustement serré de l'emboitement mutuel des embouts de connexion mâle et femelle de chaque interface de connexion.

La présente invention a également pour objet une borne de recharge de véhicules électriques, ladite borne de recharge comprenant un boîtier principal délimitant un espace interne, au moins une carte électronique fixée dans l'espace interne, au moins une prise de recharge dédiée au chargement de la batterie de stockage d'un véhicule électrique, la ou chaque borne de recharge étant soit fixe en étant fixée et sur le boîtier principal, soit mobile en étant connectée à l'extrémité d'un câble de recharge sortant du boîtier principal, ladite prise de recharge fixe ou mobile comprenant des broches de sortie d'alimentation et/ou de communication et des conducteurs reliés chacun à l'une de ces dernières, l'autre extrémité du câble de recharge se terminant par des points de raccordement reliés chacun à l'un des conducteurs de la prise de recharge mobile, les conducteurs de la prise de recharge fixe ou les points de raccordement du câble de recharge étant reliés dans l'espace interne à la carte électronique grâce à un dispositif de connexion, se caractérisant essentiellement en ce que le dispositif de connexion consiste en un dispositif de connexion rapide selon la présente invention et en ce que l'embout de fixation et de connexion de chaque premier connecteur est connecté et assujetti au conducteur ou point de raccordement concerné et l'embout de fixation et de connexion de chaque second connecteur est connecté et assujetti à la carte électronique, l'embout de connexion mâle ou femelle de chaque second connecteur étant connecté à l'embout de connexion mâle ou femelle du premier connecteur par emboitement mutuel desdits embouts de connexion.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
[Fig. 1] est une vue en perspective et en éclaté d'un dispositif de connexion rapide selon la présente invention dans une forme de réalisation adaptée pour une borne de recharge comprenant une prise de recharge fixe et dans un premier mode de réalisation de la connexion mâle/femelle des premiers et seconds connecteurs,
[Fig. 2] montre le dispositif de connexion rapide représenté sur la figure 1 à l'état connecté reliant fonctionnellement la prise de recharge à la carte électronique,
[Fig. 3] montre les premiers connecteurs et la prise de recharge fixe représentés sur la figure 1 selon un angle de vue différent,
[Fig. 4] est une vue en perspective d'un second connecteur représenté sur la figure 1,
[Fig. 5] est une vue en coupe axiale ou longitudinale du second connecteur représenté sur la figure 4,
[Fig. 6] est une vue en coupe axiale de l'ensemble représenté sur la figure 2 comprenant la prise de recharge fixe et les premiers connecteurs,
[Fig. 7] est une vue en perspective et en éclaté d'un dispositif de connexion rapide selon la présente invention dans une forme de réalisation adaptée pour une borne de recharge comprenant une prise de recharge fixe et dans un deuxième mode de réalisation de la connexion mâle/femelle des premiers et seconds connecteurs,
[Fig. 8] montre le dispositif de connexion rapide représenté sur la figure 7 à l'état connecté reliant fonctionnellement la prise de recharge à une carte électronique,
[Fig. 9] montre les premiers connecteurs et la prise de recharge fixe représentés sur la figure 7 selon un angle de vue différent,
[Fig. 10] est une vue en perspective d'un premier connecteur représenté sur la figure 7,
[Fig. 11] est une vue en coupe axiale ou longitudinale du premier connecteur représenté sur la figure 10,
[Fig. 12] est une vue en coupe axiale de l'ensemble représenté sur la figure 8 comprenant la prise de recharge fixe et les premiers connecteurs,
[Fig. 13] est une vue en perspective partielle et en éclaté d'un dispositif de connexion rapide selon la présente invention dans une autre forme de réalisation adaptée pour une borne de recharge comprenant une prise de recharge mobile et dans le deuxième mode de réalisation de la connexion mâle/femelle des premiers et seconds connecteurs,
[Fig. 14] est une vue en perspective d'une borne de recharge selon la présente invention comprenant une prise de recharge mobile et le dispositif de connexion représenté partiellement sur la figure 13 à l'état connecté dans ladite borne en reliant les points de raccordement situés à l'une des extrémités du câble de recharge muni de la prise de recharge à son autre extrémité, avec le boîtier principal de la borne de recharge ouvert sur sa face avant,
[Fig. 15a] est une vue de profil d'un premier connecteur représenté sur la figure 13 connecté et assujetti à l'un des points de raccordement à l'extrémité du câble de recharge,
[Fig. 15b] est vue en coupe axiale du premier connecteur et du point de raccordement représentés sur la figure 15a,
[Fig. 16] est une vue en coupe transversale de l'ensemble représenté sur la figure 14.
[Fig. 17] est une vue de face du boîtier principal d'une borne de recharge selon la présente invention comprenant une prise de recharge fixe et le dispositif de connexion rapide représenté sur la figure 1 ou 7,
[Fig. 18] est une vue en perspective de la borne de recharge représentée sur la figure 14 avec la face avant du boîtier principal fermée.

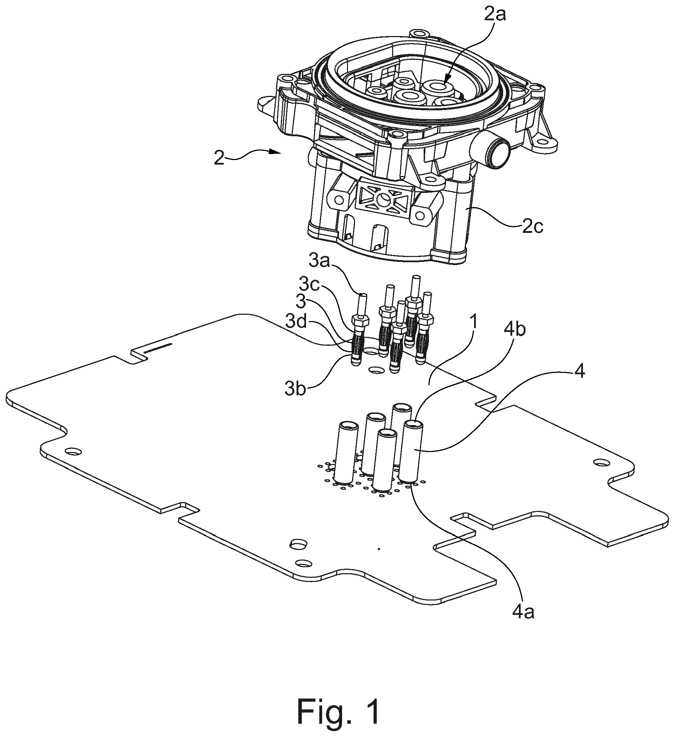

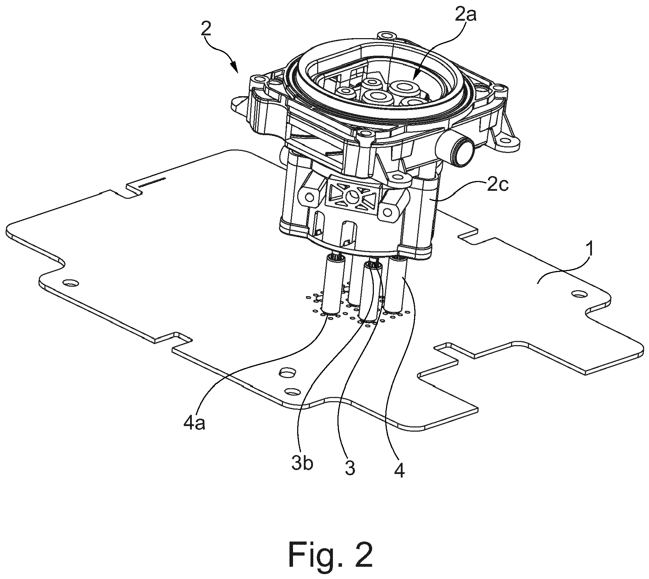

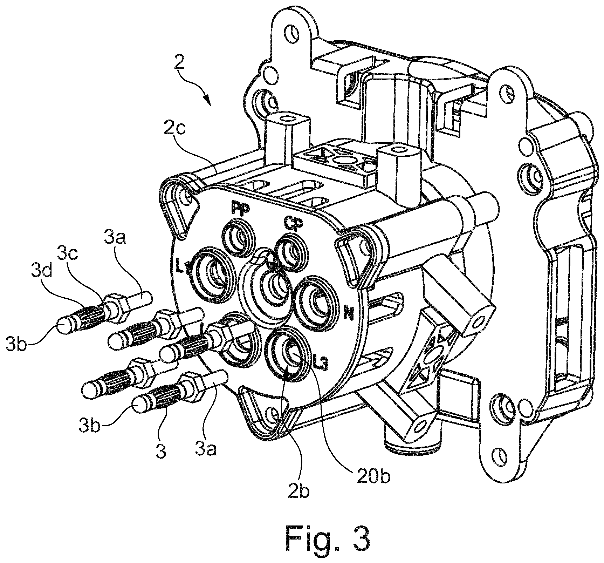

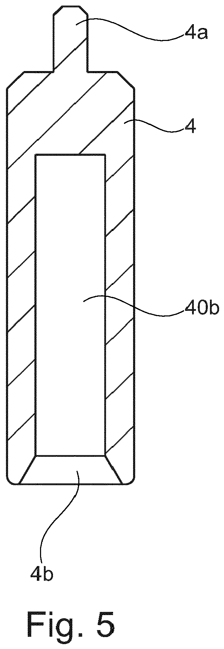

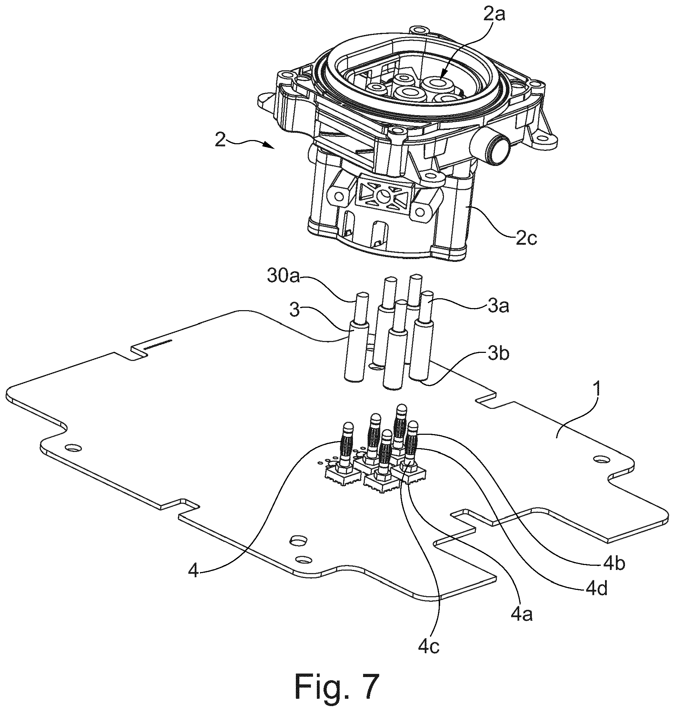

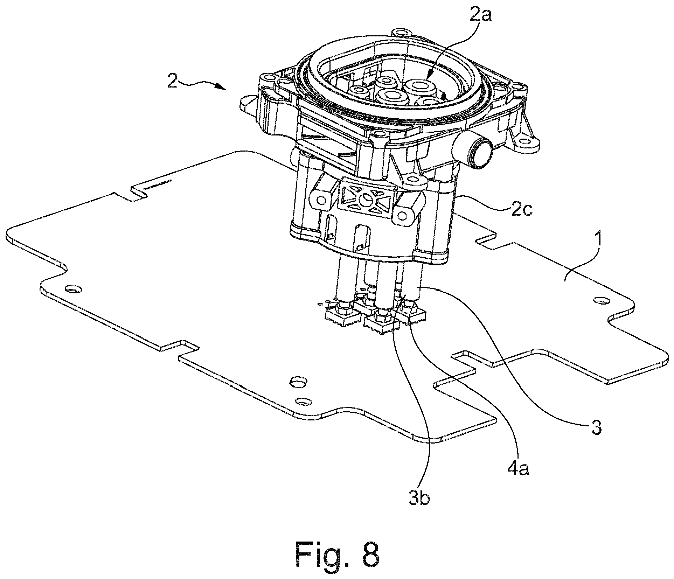

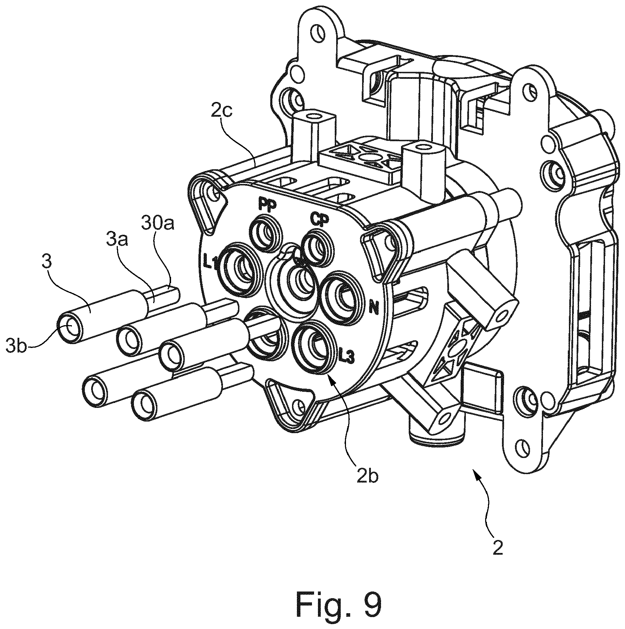

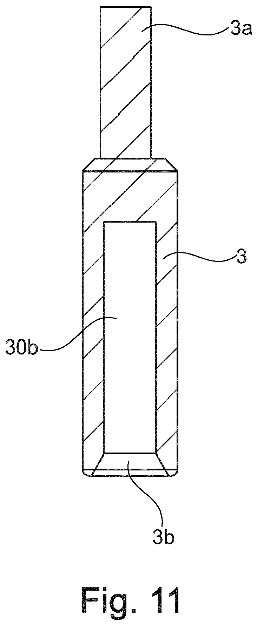

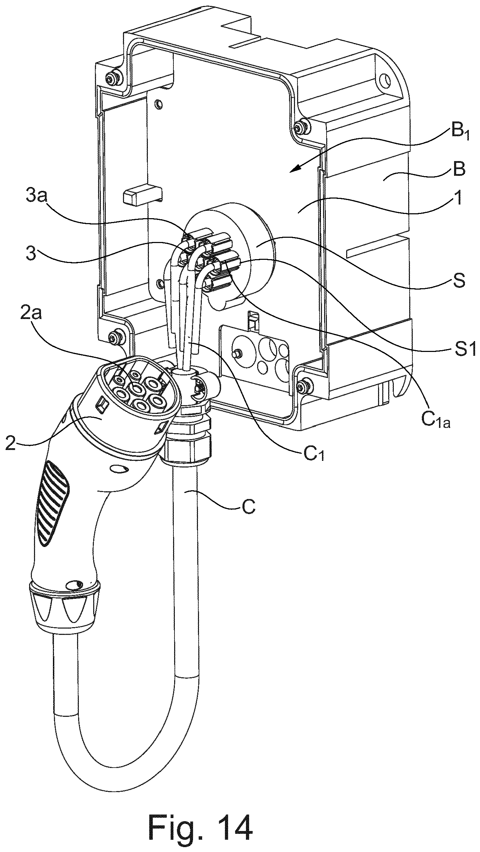

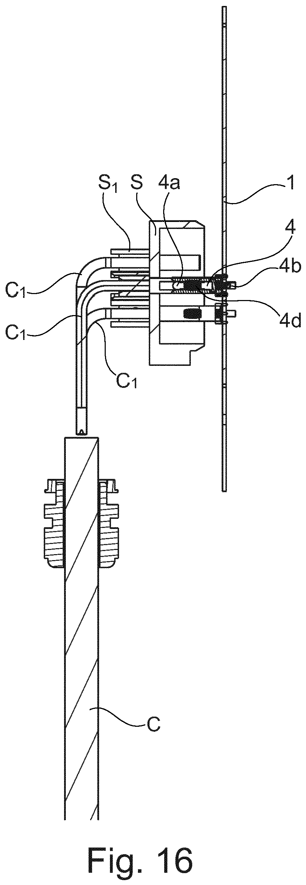

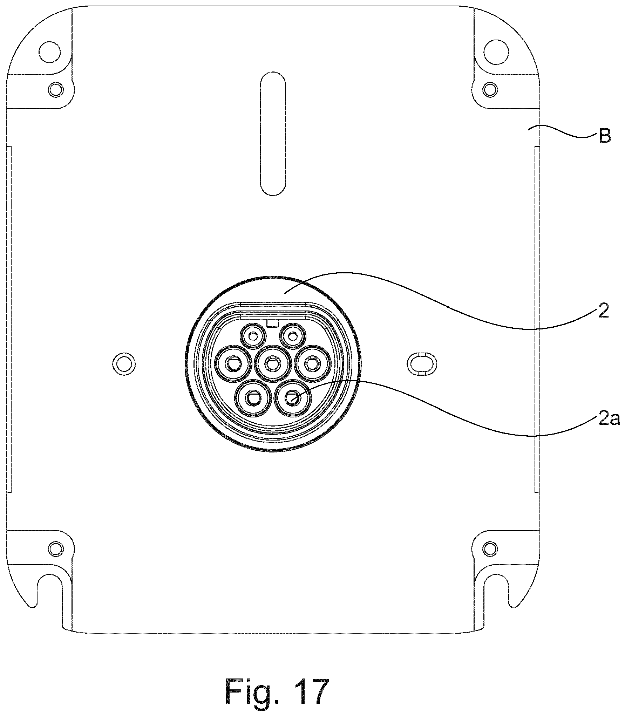

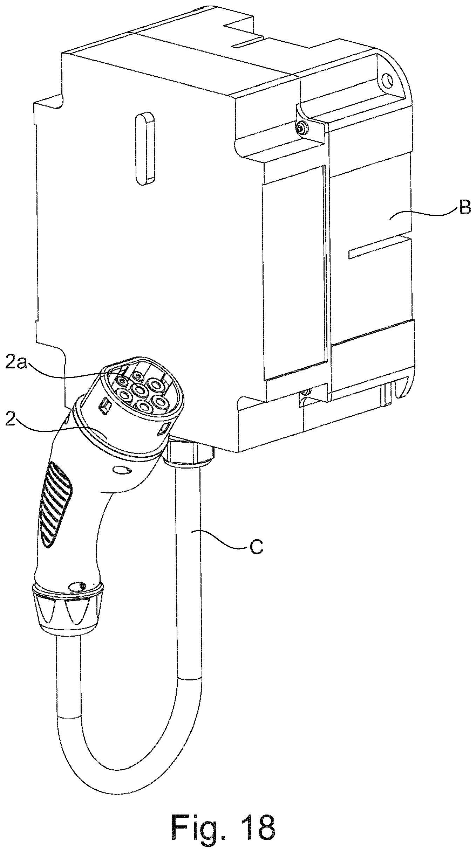

Les figures annexées montrent un dispositif de connexion rapide, selon la présente invention, pour borne de recharge de véhicules électriques. Une telle borne de recharge comprend :
- un boîtier B, dit boîtier B principal, délimitant un espace interne B1,
- au moins une carte électronique 1 fixée dans l'espace interne B1,
- au moins une prise de recharge 2 dédiée au chargement de la batterie de stockage d'un véhicule électrique. La ou chaque prise de recharge 2 est soit fixe en étant fixée sur le boîtier B principal (cas des figures 1 à 12, 17), soit mobile en étant connectée à l'extrémité d'un câble C de recharge sortant du boîtier B principal (cas des figures 7 à 14, 15a, 15b, 16, 18). Le ou chaque câble C de recharge est ainsi muni à l'une de ses extrémités, situées à l'extérieur du boîtier B principal, de la ou de l'une des prise(s) de recharge 2. L'autres extrémité du ou de chaque câble de recharge C est connectée fonctionnellement dans le boîtier B principal comme on le verra par la suite.

La ou chaque prise de recharge 2 fixe ou mobile comprend, de manière connue, des broches de sortie 2a d'alimentation et/ou de communication et des conducteurs 2b reliés chacun à l'une de ces dernières. Les broches de sortie d'alimentation 2a autorisent ou permettent chacune le passage du courant alternatif en formant chacune une phase, le neutre ou la terre. Les broches de sortie 2b d'alimentation peuvent comprendre, comme c'est le cas avec les prises de recharge standards actuelles, trois à cinq broches de sortie d'alimentation (une broche de terre, une broche de neutre et une à trois broches de phase). Les broches de sortie 2a de communication sont des broches de sortie de contrôle (connues par exemple sous les expressions anglaises de « proximity pilot » (PP) et « Control Pilot » (CP)) pour la communication de la borne de recharge B avec le véhicule électrique à recharger, notamment pour déterminer le niveau de courant maximum supportable par sa batterie et pour autoriser de façon intelligente la circulation du courant depuis la borne de recharge B vers la batterie (ou les batteries ou accumulateur(s)) du véhicule électrique.

Une telle prise de recharge 2 fixe ou mobile est une pièce standard qui répond aux normes ou standards. Par exemple, une telle prise de recharge 2 peut être une prise de recharge de type « 2 » qui est le standard européen imposée à l'ensemble des bornes de recharge et des véhicules électriques 100% électriques ou hybrides vendu(e)s dans l'union européenne. Elle comprend un boîtier 2c destiné à être fixé sur le boîtier B principal de la borne de recharge et, en étant rendus accessibles de l'extérieur, sur un côté avant du boîtier 2c, les broches de sortie 2a et, sur un côté arrière du boîtier 2c, les conducteurs 2b. Les conducteurs 2b sont maintenus dans le boitier 2c dans une position fixe les uns par rapport aux autres.

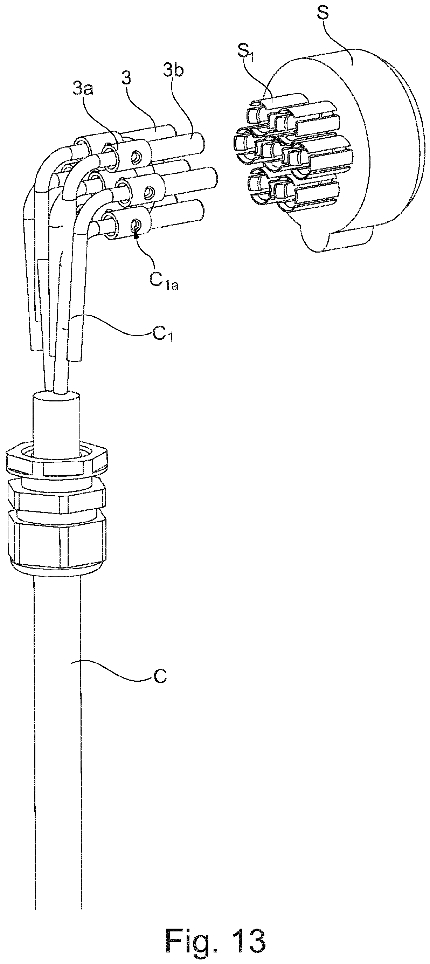

Dans le cas d'une prise de recharge 2 mobile (connectée à l'une des extrémités d'un câble de recharge C sortant du boîtier B principal d'une borne de recharge B), l'autre extrémité du câble de recharge C (opposée à celle munie de la prise de recharge 2 mobile) se termine par des points de raccordement C1a reliés chacun à l'un des conducteurs 2b de la prise de recharge 2 mobile (figures 13, 14, 16). Lesdits points de raccordement C1a permettent d'assurer la continuité électrique desdits conducteurs 2b à l'autre extrémité du câble de recharge C1 située dans l'espace interne B1 de la borne de recharge.

Conformément à la présente invention, un tel dispositif de connexion rapide selon la présente invention comprend des interfaces de connexion 3, 4 aptes et destinées chacune à relier fonctionnellement la carte électronique 1 (ou l'une des cartes électroniques 1 dans le cas où la borne de recharge comprend une pluralité de cartes électroniques 1) à l'un desdits conducteurs 2b ou points de raccordement C1a. Une telle liaison fonctionnelle réalisée par le dispositif de connexion rapide entre les conducteurs 2b de la prise de recharge 2 fixe et la carte électronique 1, ou entre les points de raccordement C1a et la carte électronique 1, permet de relier électriquement les broches de sortie 2a de la prise de recharge 2 fixe ou mobile à ladite carte électronique 1. La ou chaque carte électronique 1 est notamment un circuit imprimé (ou PCB de l'anglais « printed circuit board »), c'est-à-dire un support, en général une plaque, permettant de maintenir et de relier électriquement un ensemble de composants électroniques entre eux.

Conformément à la présente invention, chaque interface de connexion 3, 4 comporte :
- un premier connecteur 3 muni d'un embout de fixation et de connexion 3a apte et destiné à être connecté et assujetti au conducteur 2b ou point de raccordement C1a concerné et d'un embout de connexion 3b mâle ou femelle,
- et un second connecteur 4 muni d'un embout de fixation et de connexion 4a apte et destiné à être connecté et assujetti à la carte électronique 1 et d'un embout de connexion 4b mâle ou femelle apte et destiné à être connecté à l'embout de connexion 3b du premier connecteur 3 par emboitement mutuel desdits embout de connexion 3b, 4b.

Les premiers et seconds connecteurs 3, 4 présentent (chacun) une forme globalement cylindrique.

On comprend que le nombre d'interfaces de connexion 3, 4 est fonction du nombre de broches de sortie 2a à relier à la ou les carte(s) électronique(s) 1 concernée(s). A noter que, dans une telle borne de recharge, toutes les broches de sortie 2a ne sont pas toujours reliées à la carte électronique 1.

Un point de raccordement C1a forme une terminaison d'extrémité du câble de recharge C et plus particulièrement une terminaison d'extrémité de l'un des fils électriques C1 du câble de recharge C connecté à l'un des conducteurs 2b de la prise de recharge 2 mobile. Un tel point de raccordement C1a peut être formé, dans un premier cas, directement par l'extrémité dénudée de l'un des fils électriques C1 du câble de recharge C (figures 13, 14, 15a, 15b, 16). Il peut aussi être formé, dans un deuxième cas non représenté sur les figures annexées, par un élément de raccordement électrique connecté à une telle extrémité dénudée. Un tel élément de raccordement électrique peut être, par exemple, un embout de câblage ou une férule qui peuvent être sertis sur l'extrémité dénudée du fil concerné. Dans le premier cas, l'embout de fixation et de connexion 3a de chaque premier connecteur 3 peut être assujetti et connecté, par exemple, par sertissage ou vissage, à l'extrémité dénudée C1a de l'un des fils électriques C1 du câble de recharge C (figures 13, 14, 15a, 15b, 16). Dans le deuxième cas, l'embout de fixation et de connexion 3a de chaque premier connecteur 3 peut être assujetti et connecté à l'élément de raccordement, par exemple par vissage.

La présente invention peut prévoir, comme on peut le voir notamment sur les figures 13, 14 et 16, que l'ensemble des points de raccordement C1a et des premiers connecteurs 3 connectés et assujettis à ces derniers soit monté sur un support S, de préférence grâce à des fiches de réception S1 du support S prévues chacune pour recevoir l'un des premiers connecteurs 3, permettant de positionner et de maintenir dans une position fixe les uns par rapport aux autres lesdits premiers connecteurs 3. Ce positionnement permet de rendre cet ensemble de connexion, et notamment les premiers connecteurs 3, prêts à être connectés rapidement aux seconds connecteurs 4 connectés et assujettis sur la carte électronique 1 à raccorder.

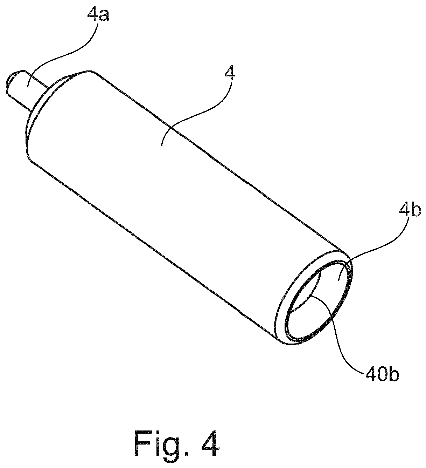

Comme on peut le voir plus particulièrement sur les figures 1, 2, 3 à 6, dans un premier mode de réalisation de la connexion mâle/femelle des premiers et seconds connecteurs 3, 4, l'embout de connexion 4b de chaque second connecteur 4 est un embout de connexion 4b femelle et l'embout de connexion 3b de chaque premier connecteur 3 est un embout de connexion 3b mâle. L'embout de connexion 4b femelle du second connecteur 4 comporte une cavité de réception 40b axiale permettant de recevoir l'embout mâle 3b du premier connecteur (figures 4, 5 et 6 notamment). Le matériau (métallique par exemple), les dimensions et la forme de l'embout de connexion 3b mâle du premier connecteur 3 et de la cavité de réception 40b axiale du second connecteur 4 sont déterminées de sorte à permettre une connexion électrique entre les deux connecteurs 3, 4.

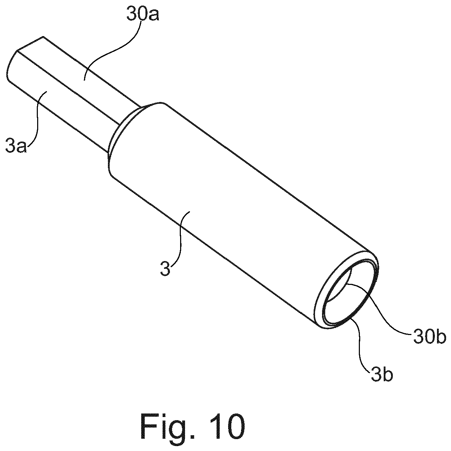

Comme on peut le voir plus particulièrement sur les figures les figures 7, 8, 9 à 12 et 16, dans un deuxième mode de réalisation de la connexion mâle/femelle des premiers et seconds connecteurs 3, 4, l'embout de connexion 4b de chaque second connecteur 4 peut être un embout de connexion 4b mâle et l'embout de connexion 3b de chaque premier connecteur 3 peut être un embout de connexion 3b femelle. L'embout de connexion 3b femelle du premier connecteur 3 comporte une cavité de réception 30b permettant de recevoir l'embout mâle 4b du second connecteur 4 (figures 10, 11 et 12 notamment). Le matériau (métallique par exemple), les dimensions et la forme de l'embout de connexion 4b mâle du second connecteur 4 et de la cavité de réception 30b axiale du premier connecteur 3 sont déterminés de sorte à permettre une connexion électrique entre les deux connecteurs 3, 4.

L'assemblage/connexion mâle/femelle entre chaque premier connecteur 3 et le second connecteur 4 correspondant, par emboitement mutuel de leurs embouts de connexion 3b, 4b mâle/femelle respectifs, permet de réaliser un(e) assemblage/connexion rapide mutuellement entre lesdits premiers et seconds connecteurs 3, 4 et donc entre les conducteurs 2b de la prise de recharge fixe, ou les points de raccordement C1a à l'extrémité concernée du câble de rechargement C, et la carte électronique 1.

La prise de recharge 2 fixe ou mobile peut être connectée, via le dispositif de connexion selon la présente invention, à une plusieurs cartes électroniques 2, c'est-à-dire à une carte électronique 1 unique réalisant toutes les fonctions nécessaires à la prise de recharge 2 fixe ou mobile en vue de sa connexion à un véhicule électrique ou à plusieurs carte électroniques 1 réalisant chacune au moins l'une desdites fonctions.

Si on se réfère notamment aux figures 1 à 12, on peut voir que chaque conducteur 2b de la prise de recharge 2 fixe présente, de manière connue, une forme de douille ou de fût. Chaque conducteur 2b comporte une cavité de réception 20b axiale. On peut voir également que la présente invention peut prévoir que l'embout de fixation et de connexion 3a de chaque premier connecteur 3 soit apte et destiné à être inséré (ou encastré) dans la cavité de réception 20b du conducteur 2b concerné de la prise de recharge 2 fixe. On peut voir également que le dispositif de connexion selon la présente invention comprend en outre des moyens de verrouillage 5 permettant d'assujettir les embouts de fixation et de connexion 3a en empêchant leur retrait hors des cavités de réception 20b respectives des conducteurs 2b concernés.

Dans le cas d'une prise de recharge 2 mobile (figures 13, 14, 16, 18 notamment), c'est-à-dire connectée (et assujettie) à l'extrémité d'un câble de recharge C sortant de la borne de recharge C, les conducteurs 2b sont identiques ou similaires à ceux d'une prise de recharge 2 fixe.

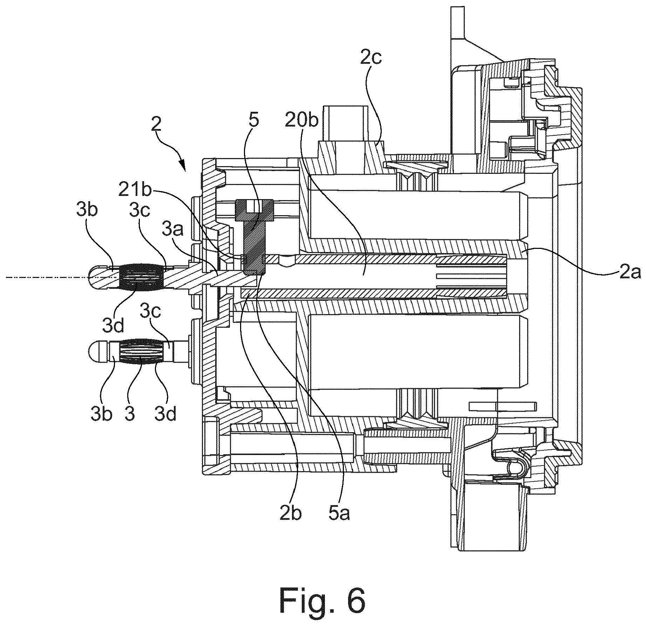

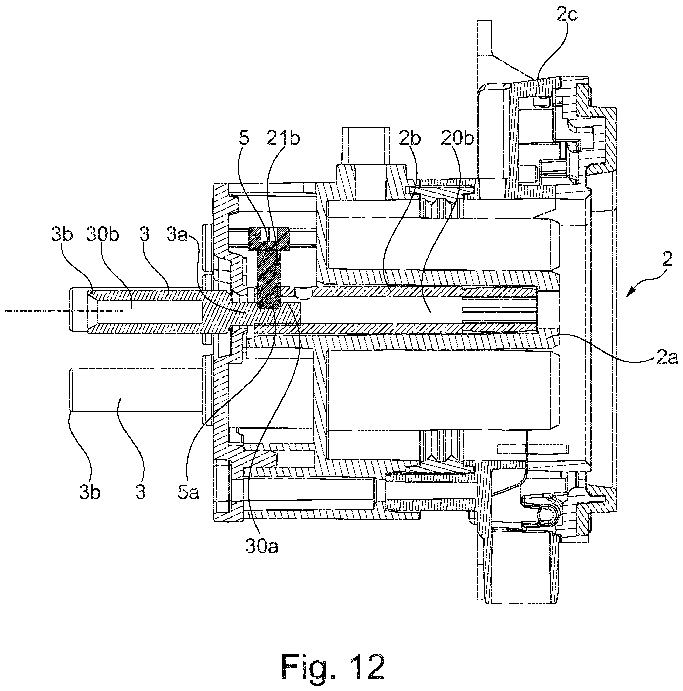

Dans le cas d'une prise de recharge 2 fixe, dans une première forme de réalisation des moyens de verrouillage 5, comme on peut le voir plus particulièrement sur les figures 6 et 12, chaque conducteur 2b comporte au moins un trou taraudé 21b débouchant transversalement dans sa cavité de réception 20b. en outre les moyens de verrouillage 5 consistent en au moins une vis de pression 5 vissée dans le ou l'un des trou(s) taraudé(s) 21b en venant appuyer par son extrémité 5a sur la surface externe, dite surface d'appui, de l'embout de fixation et de connexion 3a inséré dans la cavité de réception 20b. De préférence, comme on peut le voir notamment sur les figures 7, 9, 10, l'embout de fixation et de connexion 3a de chaque premier connecteur 3 peut comporter un méplat 30a pratiqué dans sa surface externe, ledit méplat 30a formant la surface d'appui. Le méplat 30a permet d'empêcher la rotation du premier connecteur 3 autour de son axe et d'améliorer, grâce à la surface plane du méplat 30a, la pression le serrage et donc de renforcer l'assujettissement.

Toujours dans le cas d'une prise de recharge 2 fixe, dans une autre forme de réalisation des moyens de verrouillage, non représentée sur les figures annexées, la cavité de réception 20b de chaque conducteurs 2b est taraudée et l'embout de fixation et de connexion 3a de chaque premier connecteur 3 est fileté de sorte à permettre son vissage dans la cavité de réception 2b concernée, lesdits filetage et taraudage formant les moyens de verrouillage.

Toujours dans le cas d'une prise de recharge 2 fixe, dans une troisième forme de réalisation des moyens de verrouillage, non représentée sur les figures annexées, les moyens de verrouillage consistent en un sertissage ou brasage de chaque conducteur 2b avec l'embout de connexion 3a encastré dans ce dernier.

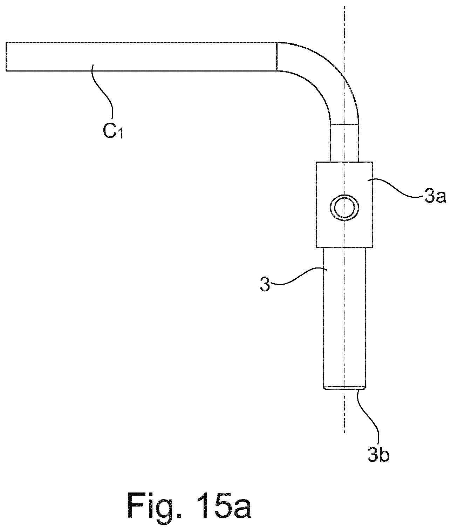

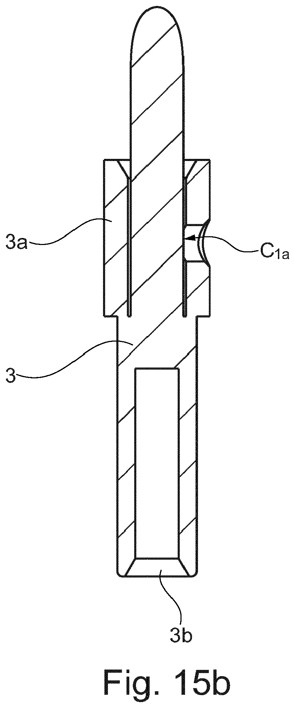

Si on se réfère maintenant aux figures 13 à 14, 15a, 15b et 16 notamment, on peut voir que l'embout de fixation et de connexion 3a de chaque premier connecteur 3 est connecté et assujetti à un point de raccordement C1a. Le point de raccordement C1a correspond à l'extrémité dénudée d'un fil C1 du câble de recharge C1 muni à son autre extrémité d'une prise de recharge 2 mobile, non représentée. Si on se réfère plus particulièrement aux figures 13, 15a et 15b, on peut voir que l'embout de fixation et de connexion 3a de chaque premier connecteur 3 peut présenter une forme de férule qui peut être sertie sur l'extrémité terminal du fil C1 concernée.

Comme on peut le voir sur les figures 1, 3, 6, 7, 9, 16, chaque embout de connexion 3b, 4b mâle comprend un corps 3c, 4c allongé et rigide et une enveloppe 3d, 4d métallique élastique externe entourant ledit corps 3c, 4c de sorte à pouvoir assurer une connexion électrique et un ajustement serré de l'emboitement mutuel des embouts de connexion 3b, 4b mâle et femelle de chaque interface de connexion 3, 4. Un tel embout de connexion 3b, 4b mâle peut être réalisé à partir d'une fiche appelée fiche « banane » qui constitue un organe de connexion électrique rapide bien connu dans le domaine des connexions/raccordements électriques.

De préférence, l'embout de connexion et de fixation 4a de chaque second conducteur 4 peut être fixé sur la carte électronique 1 par brasage.

Comme on peut le voir sur les figures 1, 2, 7, 8, 14 et 16, les seconds conducteurs 4 peuvent présenter une forme allongée, de préférence une forme globalement cylindrique. Ils peuvent s'étendre perpendiculairement au plan de la carte électronique 1.

La présente invention a également pour objet une borne de recharge de véhicules électriques telle que décrite précédemment, c'est-à-dire qu'elle comprend essentiellement :
- un boîtier B principal délimitant un espace interne B1,
- au moins une carte électronique 1 fixée dans l'espace interne B1,
- au moins une prise de recharge 2 dédiée au chargement de la batterie de stockage d'un véhicule électrique. La ou chaque prise de recharge 2 est soit fixe en étant fixée sur le boîtier B principal, soit mobile en étant connectée à l'extrémité d'un câble C de recharge sortant du boîtier B principal.

La ou chaque prise de recharge 2 fixe ou mobile comprend des broches de sortie 2a d'alimentation et/ou de communication et des conducteurs 2b reliés chacun à l'une de ces dernières. L'autre extrémité du câble de recharge C se termine par des points de raccordement C1a reliés chacun à l'un des conducteurs 2b de la prise de recharge 2 mobile.

Les conducteurs 2b de la prise de recharge 2 fixe (ou de l'une des prises de recharge 2 fixes dans le cas d'une pluralité de prises de recharge 2) ou les points de raccordement C1a du câble de recharge C (ou de l'un des câbles de recharge C dans le cas d'une pluralité de câbles de recharge C) sont reliés dans l'espace interne B1 à la carte électronique 1 (ou à l'une des cartes électroniques 1 dans le cas d'une pluralité de cartes électroniques 1 grâce à un dispositif de connexion.

On comprend qu'une telle borne peut comprendre plusieurs dispositifs de connexion dans le cas d'une pluralité de prises de recharge 2 fixes ou mobiles.

Conformément à la présente invention, dans une telle borne de recharge B, le dispositif de connexion consiste en un dispositif de connexion rapide selon la présente invention tel que décrit précédemment et dont l'embout de fixation et de connexion 3a de chaque premier connecteur 3 est connecté et assujetti au conducteur 2b ou point de raccordement C1a concerné et l'embout de fixation et de connexion 4a de chaque second connecteur 4 est connecté et assujetti à la carte électronique 1, l'embout de connexion 4b mâle ou femelle de chaque second connecteur 4 étant connecté à l'embout de connexion 3b mâle ou femelle du premier connecteur 3 par emboitement mutuel desdits embouts de connexion 3b, 4b.

On comprend que dans le cas d'une pluralité de cartes électroniques 1, l'embout de fixation et de connexion 4a de chaque second connecteur 4 est connecté et assujetti à l'une des carte(s) électronique(s) 1.

Ainsi, un tel dispositif de connexion rapide selon la présente invention, et une telle borne équipée d'un tel dispositif de connexion rapide permettent notamment à l'installateur ou au monteur (personne physique ou robot de montage), sur site ou en usine, de réaliser une connexion rapide dans la borne de recharge , c'est-à-dire dans l'espace interne B1 de son boîtier B principal, entre l'électronique (la ou les cartes électroniques 1) et la prise de recharge 2, c'est-à-dire sans utiliser d'outils spécifiques, ni de câbles de raccordement. Un tel dispositif de connexion rapide offre ainsi, plus particulièrement au fabricant et/ou à l'installateur/monteur et/ou au particulier :
- un gain de temps en production (moins de main d'oeuvre),
- un gain de coût (moins de cuivre),
- un gain de temps et simplification de l'installation (pas de vissage / pas d'outils pour visser la prise),
- une réduction du risque lors de l'installation (pas de mauvais câblage),
- une manutention facilitée,
- des pièces de rechange plus simples.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif de connexion rapide pour borne de recharge de véhicules électriques, ladite borne de recharge comprenant un boîtier (B) principal, délimitant un espace interne (B1), au moins une carte électronique (1) fixée dans l'espace interne (B1), au moins une prise de recharge (2) dédiée au chargement de la batterie de stockage d'un véhicule électrique, la ou chaque prise de recharge (2) étant soit fixe en étant fixée sur le boîtier (B) principal, soit mobile en étant connectée à l'extrémité d'un câble (C) de recharge sortant du boîtier (B) principal, ladite prise de recharge (2) fixe ou mobile comprenant des broches de sortie (2a) d'alimentation et/ou de communication et des conducteurs (2b) reliés chacun à l'une de ces dernières, l'autre extrémité du câble de recharge (C) se terminant par des points de raccordement (C1a) reliés chacun à l'un des conducteurs (2b) de la prise de recharge (2) mobile, **caractérisé en ce qu'**il est apte et destiné à relier dans l'espace interne (B1) les conducteurs (2b) de la prise de recharge (2) fixe ou les points (C1a) de raccordement du câble de recharge (C) à la carte électronique (1) et **en ce qu'**il comprend des interfaces de connexion (3, 4) aptes et destinées chacune à relier fonctionnellement la carte électronique (1) à l'un desdits conducteurs (2b) ou points de raccordement (C1a), une telle liaison fonctionnelle réalisée par ledit dispositif de connexion rapide entre les conducteurs (2b) de la prise de recharge (2) fixe et la carte électronique (1), ou entre les points de raccordement (C1a) et la carte électronique (1), permettant de relier électriquement les broches de sortie (2a) de la prise de recharge (2) fixe ou mobile à ladite carte électronique (1), chaque interface de connexion (3, 4) comportant un premier connecteur (3) muni d'un embout de fixation et de connexion (3a) apte et destiné à être connecté et assujetti au conducteur (2b) ou point de raccordement (C1a) concerné et d'un embout de connexion (3b) mâle ou femelle et un second connecteur (4) muni d'un embout de fixation et de connexion (4a) apte et destiné à être connecté et assujetti à la carte électronique (1) et d'un embout de connexion (4b) mâle ou femelle apte et destiné à être connecté à l'embout de connexion (3b) du premier connecteur (3) par emboitement mutuel desdits embout de connexion (3b, 4b), les premiers et seconds connecteurs (3, 4) présentant une forme globalement cylindrique et **en ce que** l'embout de connexion (3b, 4b) mâle des premiers ou seconds connecteurs (3, 4) comprend un corps (3c, 4c) allongé et rigide et une enveloppe (3d, 4d) métallique élastique externe entourant ledit corps (3c, 4c) de sorte à pouvoir assurer une connexion électrique et un ajustement serré de l'emboitement mutuel des embouts de connexion (3b, 4b) mâle et femelle de chaque interface de connexion (3, 4).

2. Dispositif de connexion, selon la revendication 1, **caractérisé en ce que** l'embout de connexion (4b) de chaque second connecteur (4) est un embout de connexion (4b) femelle et **en ce que** l'embout de connexion (3b) de chaque premier connecteur (3) est un embout de connexion (3b) mâle.

3. Dispositif de connexion, selon la revendication 1, **caractérisé en ce que** l'embout de connexion (4b) de chaque second connecteur (4) est un embout de connexion (4b) mâle et **en ce que** l'embout de connexion (3b) de chaque premier connecteur (3) est un embout de connexion (3b) femelle.

4. Dispositif de connexion, selon l'une quelconque des revendications 1 à 3, **caractérisé en ce que** chaque conducteur (2b) de la prise de recharge (2) fixe présente une forme de douille ou de fût comportant une cavité de réception (20b) axiale et l'embout de fixation et de connexion (3a) de chaque premier connecteur (3) est apte et destiné à être inséré dans la cavité de réception (20b) du conducteur (2b) concerné et **en ce qu'**il comprend en outre des moyens de verrouillage (5) permettant d'assujettir les embouts de fixation et de connexion (3a) en empêchant leur retrait hors des cavités de réception (20b) respectives des conducteurs (2b) concernés.

5. Dispositif de connexion, selon la revendication 4, **caractérisé en ce que** chaque conducteur (2b) comporte au moins un trou taraudé (21b) débouchant transversalement dans sa cavité de réception (20b) et **en ce que** les moyens de verrouillage (5) consistent en au moins une vis de pression vissée dans le ou l'un des trou(s) taraudé(s) (21b) en venant appuyer par son extrémité (5a) sur la surface externe, dite surface d'appui, de l'embout de fixation et de connexion (3a) inséré dans la cavité de réception (20b).

6. Dispositif de connexion, selon la revendication 5, **caractérisé en ce que** l'embout de fixation et de connexion (3a) de chaque premier connecteur (3) comporte un méplat (30a) pratiqué dans sa surface externe et formant la surface d'appui.

7. Dispositif de connexion, selon la revendication 4, **caractérisé en ce que** les moyens de verrouillage consistent en un sertissage ou brasage de chaque conducteur (2b) avec l'embout de connexion (3a) encastré dans ce dernier.

8. Borne de recharge de véhicules électriques, ladite borne de recharge comprenant un boîtier (B) principal délimitant un espace interne (B1), au moins une carte électronique (1) fixée dans l'espace interne (B1), au moins une prise de recharge (2) dédiée au chargement de la batterie de stockage d'un véhicule électrique, la ou chaque borne de recharge (2) étant soit fixe en étant fixée et sur le boîtier (B) principal, soit mobile en étant connectée à l'extrémité d'un câble (C) de recharge sortant du boîtier (B) principal, ladite prise de recharge (2) fixe ou mobile comprenant des broches de sortie (2a) d'alimentation et/ou de communication et des conducteurs (2b) reliés chacun à l'une de ces dernières, l'autre extrémité du câble de recharge (C) se terminant par des points de raccordement (C1a) reliés chacun à l'un des conducteurs (2b) de la prise de recharge (2) mobile, les conducteurs (2b) de la prise de recharge (2) fixe ou les points de raccordement (C1a) du câble de recharge (C) étant reliés dans l'espace interne (B1) à la carte électronique (1) grâce à un dispositif de connexion, **caractérisée en ce que** le dispositif de connexion consiste en un dispositif de connexion rapide selon l'une quelconque des revendications 1 à 7 et **en ce que** l'embout de fixation et de connexion (3a) de chaque premier connecteur (3) est connecté et assujetti au conducteur (2b) ou point de raccordement (C1a) concerné et l'embout de fixation et de connexion (4a) de chaque second connecteur (4) est connecté et assujetti à la carte électronique (1), l'embout de connexion (4b) mâle ou femelle de chaque second connecteur (4) étant connecté à l'embout de connexion (3b) mâle ou femelle du premier connecteur (3) par emboitement mutuel desdits embouts de connexion (3b, 4b).
